Europäisches Patentamt

European Patent Office

Office européen des brevets

(11) Publication number: **0 482 575 A2**

# EUROPEAN PATENT APPLICATION

(21) Application number: **91117983.6**

(22) Date of filing: **22.10.91**

(51) Int. Cl.5: **G06F 12/08**

(30) Priority: **26.10.90 US 604785**

(43) Date of publication of application:
**29.04.92 Bulletin 92/18**

(84) Designated Contracting States:
**DE FR GB IT**

(71) Applicant: **SAMSUNG SEMICONDUCTOR, INC.**
**3725 North First Street**
**San Jose, California 95134-1708(US)**

(72) Inventor: **Sponring, Otto**
**2666 Tures Road**
**San Jose, CA 95122(US)**

(74) Representative: **Zenz, Joachim Klaus,**
**Dipl.-Ing. et al**
**Patentanwälte Zenz, Helber & Hosbach Am**
**Ruhrstein 1**
**W-4300 Essen 1(DE)**

(54) Storage system for a high-performance processor.

(57) A main memory for a high-performance processor is provided using DRAM. The DRAM is divided into multiple memory banks (20A ... 20D), and each are set up with different row addresses based on power reset code, data, and movement of the address access separated by data and code dominance. As a result, the number of wait states required for DRAM access is reduced, and the number of successful memory accesses is increased. Each of the memory banks defined in the DRAM contains different pages of memory. This improves the overall system access because the page access of DRAM is the same as for a static RAM. A look-ahead algorithm is implemented to predict which pages will be required, so that these pages can be provided to the DRAM memory banks.

FIG. 3

## BACKGROUND OF THE PRESENT INVENTION

### 1. FIELD OF THE INVENTION

This invention relates to the field of a multiple page dynamic random access memory (DRAM).

### 2. BACKGROUND ART

A computer system consists of a number of modules or components. Computer systems typically include a central processing unit (CPU) such as a microprocessor. The microprocessor is a program-controlled device that obtains, decodes an executes instructions. A computer system also includes program storage components for storing program instructions, and data storage components for storing data. These storage components may be read only memory (ROM), random access memory (RAM), disc or tape storage, or any other suitable storage means.

A computer system also includes input/output (I/O) components for connecting external devices to the microprocessor. Special purpose components, such as memory management units or co-processors may also be part of the computer system.

The memory component, also known as a "main memory", is a scarce resource that is dynamically allocated to users, programs, or processes. Main memory is typically a silicon based memory such as a random access memory (RAM). In many prior art applications, dynamic random access memory (DRAM) is used as the main memory.

A disadvantage of the use of DRAM as main memory for a CPU or other processor are limitations on the memory access time. As microprocessor technology has improved, the clock rate of operation of the microprocessor has increased. This increases the memory access time requirements of the main memory associated with the microprocessor. The access time of DRAM has not kept pace with the requirements of present microprocessor technology. For example, 16 and 32 bit microprocessors may require memory access rates of 20 to 40 nanoseconds. Present day DRAM has access times of 60 to 80 nanoseconds. To satisfy the access requirements of present-day microprocessors, memory caching schemes or page access schemes are utilized.

Therefore, it is an object of the present invention to provide a main memory for a high-performance microprocessor that uses DRAM.

It is another object of the present invention to provide main memory for a microprocessor that uses DRAM but provides SRAM performance.

## SUMMARY OF THE PRESENT INVENTION

Main memory for a high-performance processor is provided using DRAM. The DRAM is divided into multiple memory banks, and each are set up with different row addresses based on power reset code, data, and movement of the address access separated by data and code dominance. As a result, the number of wait states required for DRAM access is reduced, and the number of successful memory accesses is increased. Each of the memory banks defined in the DRAM contains different pages of memory. This improves the overall system access because the page access of DRAM is the same as for a static RAM. A look-ahead algorithm is implemented to predict which pages will be required, so that these pages can be provided to he DRAM memory banks.

## BRIEF DESCRIPTION OF THE DRAWINGS

Figure 1 is a block diagram of a prior art cache system.
Figure 2 is a block diagram of another prior art cache system.
Figure 3 is a block diagram of the present invention.
Figure 4 is a block diagram of a memory array configuration of the present invention.
Figure 5 is a detailed block diagram of the controller of Figure 3.
Figure 6 is a flow diagram of memory access of this invention.
Figure 7 illustrates a number of parallel operations of the page setup scheme of this invention.

DETAILED DESCRIPTION OF THE INVENTION

A method and apparatus for page prediction for a multiple page DRAM is described. In the following description, numerous specific details such as number of bits, number of memory banks, etc, are set forth in detail in order to provide a more through description of the invention. It will be apparent, however, to one skilled in the art, that the present invention may be practiced without these specific details. In other instances, well-known features have not been described in detail so as not to unnecessarily obscure the present invention.

A microprocessor or central processing unit (CPU) is a device for obtaining, decoding and executing instructions. A microprocessor requires an associated memory to hold information. This memory is referred to as "main memory" and is used to hold instruction sequences (programs) and to store data. Two characteristics that affect the performance of a microprocessor memory system are capacity and speed.

The speed of a memory depends on the "access time", "write time", and "memory cycle time". The "access time" of a memory corresponds to the time required to provide a read control signal to the memory and apply the address bits to memory, until the output of the memory is valid. "Write time" is the time between the sending of a write signal to memory and the writing of new data to the memory. "Memory cycle time" is the time period required to complete a specific memory function, such as a read/write operation, a read/read operation, a write/write operation, or a write/read operation.

Main memory in a computer system has a logical organization and a physical organization. The physical organization of the main memory of a computer system typically consists of a memory array coupled to a computer system bus for communication with a microprocessor and other computer system components. Each address location in the main memory is accessed by a "physical address". The physical main memory location in which informational items may be stored is called the physical address space or the physical memory space.

An address used by or generated by a program to specify a particular informational item is called a "logical address." The set of logical addresses used by a program to identity informational items is called the "logical address space." The logical organization of a memory must include a mapping means for converting a logical address space to a physical address space. (It should be noted that the logical address space need not be equal in size to the physical address space.)

In many applications, it is desired to provide a greater logical address space than the physical address space of main memory. This is accomplished through a technique known as "virtual memory." In a virtual memory scheme, the logical address space is represented in both the physical main memory and in mass storage or auxiliary storage such as hard disk drives or floppy disk drives. A virtual memory scheme requires a mechanism to determine whether an addressed element resides in main memory or in auxiliary mass storage. When an addressed item does not reside in physical memory, it must be transferred from auxiliary storage in a process known as "swapping". A swapping operation is a time-consuming operation that requires microprocessor supervision and interrupts the execution of a program. Individual memory elements are not swapped in virtual memory schemes, but rather, blocks of memory elements are defined and when a memory element is to be transferred from main memory to auxiliary memory (or vice versa), the entire block containing that memory element is transferred. These schemes are known as "segmentation" or "paging schemes".

In segmentation schemes, arbitrarily sized blocks of memory are transferred from mass storage to main memory. A disadvantage of segmentation schemes is the time required to swap large memory segments.

Memory paging scheme permits main memory to be allocated in small blocks of equal size called "page frames". A "page" (set of contiguous logical addresses) fits within a page frame. Paging permits the implementation of a logical address space larger then the installed physical memory. If a reference page is missing from a memory, it is swapped in from mass storage as a single unit; that is, the entire page is swapped into main memory.

Even with paging schemes, memory speed can reduce system performance. The access times of DRAM's are not low enough for high performance microprocessor operation. Without a suitable compensation scheme for the disparity and access times, zero wait state operation cannot be achieved without the use of SRAM caches.

One prior art solution is the use of an associative static RAM memory (SRAM), which is used to access frequently-used data. The associative static RAM memory scheme is a "cache" scheme and is a prior art attempt to compensate for DRAM access times which are slower than the desired access time of the microprocessor.

A cache memory is a fast and relatively small memory located between the processor and larger main memory. Typically, the cache memory is high speed static RAM (SRAM) and the main memory is slower DRAM. The goal of the cache memory is to make the large main memory appear as a high speed SRAM. To accomplish this, system and application data is stored in the DRAM and copies of the programs and data most often accessed are stored in the SRAM. The information stored in the SRAM is updated periodically to reflect changes in memory elements likely to be accessed.

A cache is most effective if a high percentage of processor accesses are for information stored in the cache. The percentage of the processor accesses that are stored in the cache is referred to as the "cache hit rate". The higher the hit rate, the more efficient the memory system.

A disadvantage of caching schemes is that a DRAM read cycle is not started until after it is determined that a required memory location is not found in the static RAM cache. Therefore, cache misread cycles actually take longer than a DRAM read cycle would take if no cache system was used. If the hit rate of the cache system becomes too low, the overall performance can be less than if no cache were used.

A cache system may be a "direct mapped" cache or an "associative" cache. In a direct map cache, each location in a DRAM is directly mapped into only one cache entry. When a cache needs to store the contents of a new location, there is only one cache entry that can be used. Correspondingly, when a processor makes a memory access, only one entry of the cache must be checked to determine if information is stored in the cache.

An associative cache allows the contents of a DRAM location to be placed in any entry of the cache memory. When new information is to be stored in the cache, an algorithm is implemented to determine which cache entry is least likely to be required again in the near future. That entry is then overwritten by the contents of the new location. Whenever a processor makes a memory access, every entry of the cache must be checked to determine if the information is stored in the cache.

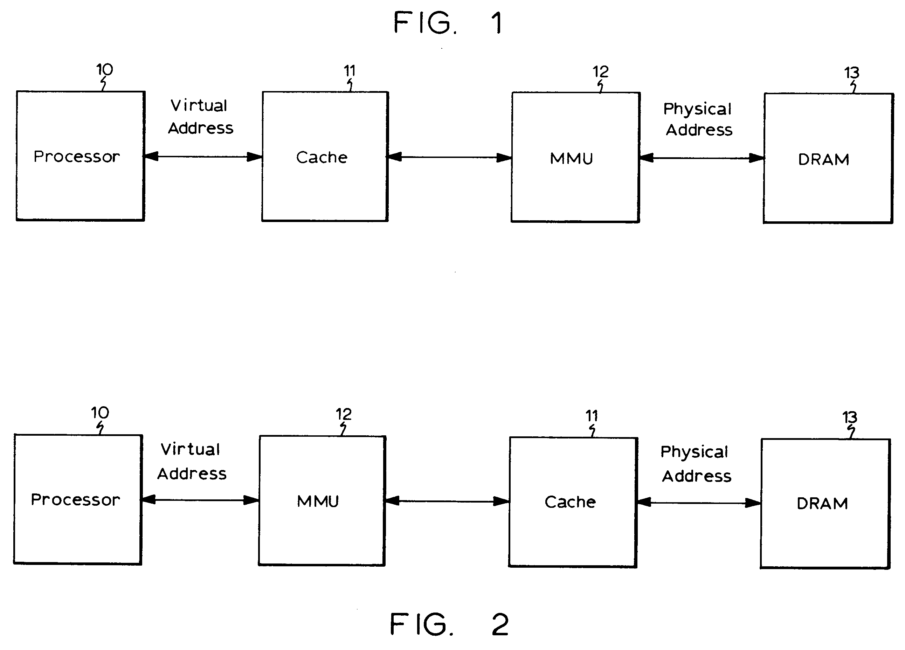

Caching schemes can be used in a virtual memory environment and are configured as "virtual address cache" schemes or "physical address cache" schemes. Figure 1 illustrates a virtual address cache scheme where the cache is located between the processor and the memory management unit (MMU). This allows the processor to make fast accesses to the cache. This is because cache hits do not require the MMU conversion delay so that cache bus cycles can be performed faster than if the conversion was required. However, this system has a disadvantage in a multi-tasking environment, because the same virtual addresses are often used by different tasks (programs). This requires that the entire cache to be "flushed" (emptied) every time the processor switches tasks because all prior cache entries become invalid. The hit rate is lowered when such a change of tasks is initiated because the cache is empty at the beginning of the new task.

Referring to Figure 1, a virtual address cache scheme is illustrated. A processor provides a virtual address (logical address) to a cache memory 11. If the virtual address is not located in the cache memory 11, the virtual address is provided to an MMU 12 where it is converted to a physical address. The physical address is provided to a DRAM 13 and the desired memory element is then provided to the MMU, converted to a logical address and provided to the cache 11 for access by the processor.

The disadvantage of task switching can be overcome by a physical address cache, as illustrated in Figure 2. In the physical address cache, a processor 10 provides a virtual address to an MMU 12. The MMU translates the virtual address into a physical address and retrieves the data from the cache 11 if available. Otherwise the physical address is provided to the DRAM 13 and the data is provided throughout the cache and the MMU to the processor 10. The physical address cache scheme of Figure 2 is not affected by task switching because the virtual address is converted by the MMU prior to accessing the cache memory 11. Thus, even though different applications may share the same virtual address, there is no need to flush the cache memory 11 when a task is switched because the translation to a physical address is accomplished prior to accessing the cache. A disadvantage of the physical address cache scheme is that the time required for conversion of the virtual address to the physical address is required for each memory access.

## PRESENT INVENTION

The present invention is a method and apparatus for providing main memory for a computer system utilizing DRAM only, with no static RAM cache required. The invention provides fast access times by utilizing interleaved banks of DRAM memory and a paging memory access scheme. A page prediction algorithm increases the hit rate to improve memory performance.

This invention interleaves multiple banks of DRAM's to reduce the effective cycle time of the DRAM. Generally, each bank of memory consists of $2^n$ contiguously addressed physical locations numbered from zero to n, where n is the number of bits in an address issued by the CPU of the computer system.

An interleaving scheme can provide improved operation if the memory accesses are sequential. The interleave scheme is used to "hide" the precharge time of the DRAM's (which affect access time) for sequential addressing. However, effective access time can also be improved by using a scheme known as fast page mode (or static column mode). This permits the microprocessor to access memory elements in page mode if the accesses are within a given page range. If a memory access is made to memory locations not present in existing pages, this is termed a "miss". A memory access to locations present in existing pages is referred to as a "hit". A system using such a technique undergoes a full DRAM precharge penalty during a miss.

The present invention provides a page memory scheme using interleaved banks of DRAM that provides the responsiveness of a cached static RAM system without the expense and complexity. No caching is required using the present invention.

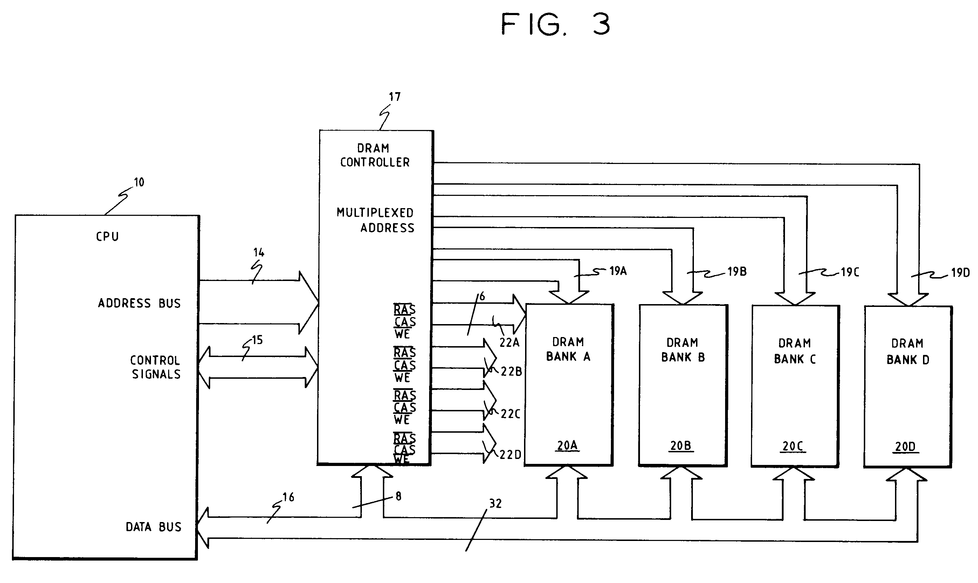

A block diagram of the present invention is illustrated in Figure 3. A microprocessor or CPU 10 includes an address bus 14, control bus 15 and data bus 16. The address bus 14 is coupled to a DRAM controller 17. The DRAM controller communicates on buses 19A-19D to DRAM memory banks 20A - 20D, respectively. RAS and CAS signals for memory banks 20A-20D are provided on 6 bit control lines 22A-22D, respectively.

The four memory banks are driven by four independent channels 19A-19D. The memory array is between 1 and 256 megabytes in the present invention but can be any suitable size. Each DRAM can be 250 k bit, 1 Mbit, 4 Mbit or 16 Mbit. While one of the memory banks is accessed, the three remaining banks are loaded in advance in order to avoid wait states when the program advances from the current bank or page. The memory banks are interleaved so that the physical addresses on any given page of memory are stacked above each other. An example of the memory organization of the DRAM memory banks is as follows. In this example, a 256k x 4 DRAM having a 9 bit wide row address equivalent to 512 pages is utilized:

| Address MSB A21 Row | Bank | Column LSB A2 | Bank | Page |
|---|---|---|---|---|
| 00000000 | 00 | 000000000 | 0 | 0 |
| = | | = | = | = |
| = | | = | = | = |
| 00000000 | 00 | 111111111 | 0 | 0 |
| 00000000 | 01 | 000000000 | 1 | 0 |
| = | | = | = | = |
| = | | = | = | = |
| 00000000 | 01 | 111111111 | 1 | 0 |
| 00000000 | 10 | 000000000 | 2 | 0 |
| = | | = | = | = |
| = | | = | = | = |
| 00000000 | 10 | 111111111 | 2 | 0 |
| 00000000 | 11 | 000000000 | 3 | 0 |
| = | | = | = | = |
| = | | = | = | = |
| 00000000 | 11 | 111111111 | 3 | 0 |
| 00000001 | 00 | 000000000 | 0 | 1 |
| = | | = | = | = |
| = | | = | = | = |
| 00000001 | 00 | 111111111 | 0 | 1 |
| 00000001 | 01 | 000000000 | 1 | 1 |
| 00000001 | 01 | 111111111 | 1 | 1 |
| = | | = | = | = |
| = | | = | = | = |
| = | | = | = | = |
| 111111111 | 11 | 000000000 | 3 | 511 |
| = | | = | = | = |
| 111111111 | 11 | 111111111 | 3 | 511 |

The present invention achieves high performance by incorporating a unique page replacing algorithm that takes into account the movement of code and data fetches. For both code movement and data fetches, the page setup is optimized to guarantee a high hit rate. The hit rate is in the range of 80 to 100 percent so that the wait states averages between 0 and 0.2. The algorithm operates on a program code data fetch look ahead. By predicting where code or data fetches of successive memory access will occur, the non-active pages can be set up in advance with the more recent results of the prediction. Conventional cache controllers fetch data into the cache memory when a cache miss occurs and prefetch one or more lines. Therefore, a miss always results in a DRAM access meaning that one or more wait states will occur. The present invention increases the hit rate by monitoring the movement of code and data. Based on this movement, the controller determines how to set up DRAM pages in advance before a page change occurs. If the prediction is correct, the page change will not necessarily result in a wait state.

A high hit rate is also accomplished by mapping the address space in contiguous banks so that a linearly progressing program will access distinguished pages. Therefore, a page change will not result in a wait state for precharging the memory.

DRAM timing consists of three basic parts, namely propagation time, the RAS/(tRAC), CAS/(tCAC) and column address access time (tAA) and precharge time. The propagation delay of a DRAM is the DRAM cycle time plus the propagation delay incurred by the address multiplexer and input and output buffers. The present invention reduces address delay by dividing the memories into four separate arrays which can consist of 9 to 36 DRAM's. This reduces the capacitive load to between 45 and 180 picofarads. The propagation time of the column address has been reduced by the integrated high speed path for the column address. This makes it possible to achieve zero wait states in a non-pipelining mode. Refresh time can be hidden in the memory acces cycles. While one memory bank is accessed, the three remaining banks are being refreshed each time a refresh is requested. The refresh is a CAS\ before RAS\ refresh, giving the advantage of reducing switching current compared to an RAS\only refresh.

An individual memory bank can be selected for a maximum time in the preferred embodiment of the present invention of 100 microseconds. After that time, the row has to be precharged. The present invention maintains a count of the internal refresh requests and de-asserts the RAS/line after five requests (which occurs after approximately 75 microseconds). After one refresh has been completed, the page address is reloaded into the DRAM bank. The remaining pages are continuously being refreshed whenever a refresh is requested which occurs approximately every 15 microseconds. All pending refreshes are performed as soon as there are no fetches to the particular bank. An access will be granted when multiple refreshes are performed, however, a refreshing progress will be completed before the access can start. With this refresh scheme, the refresh overhead is reduced to virtually zero.

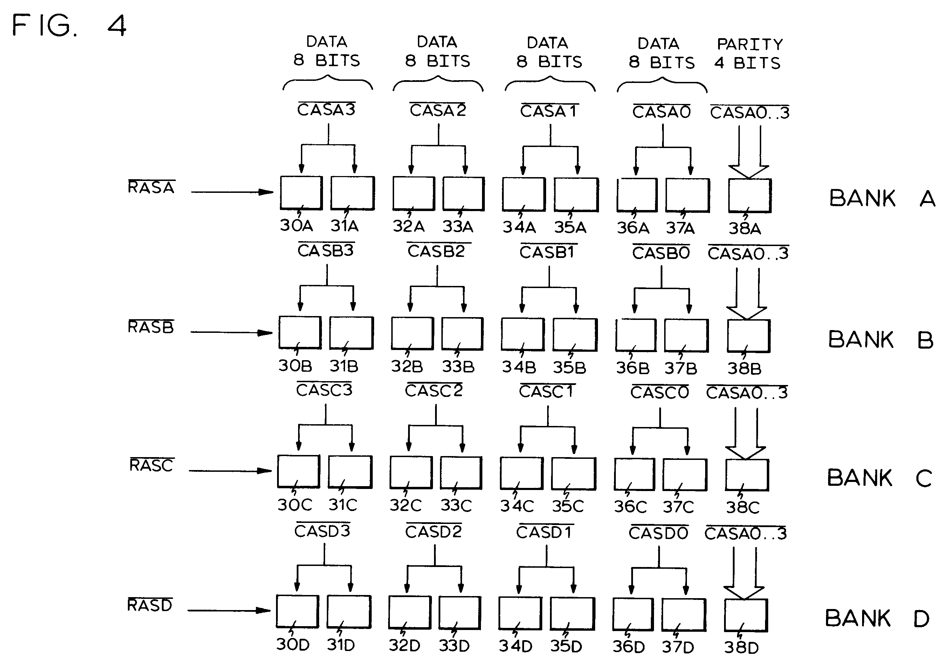

A memory configuration used in the present invention is illustrated in Figure 4. In this example, the memories are divided into four separate arrays of 9 memories each, identified as bank A through D. Bank A contains memories 30A-38A; Bank B contains memories 30B-38B; Bank C includes memories 30C-38C, and Bank D includes memories 30D-38D. Each memory can be 64 kilobits by 4,256 kilobits by 4 or one megabyte x 4. Memories 38A-38D receive parity bits for data validation.

Row address select signals RASA-RASD are provided to memory banks A-D respectively, to select a row in the memory array. Column select signals the select the appropriate column so the desired memory element may be read. Referring to bank A, column select signals CASA 0-CASA 3 are provided. CASA 0 is coupled to memory banks 36A and 37A. Signal CASA 1 is coupled to banks 34A and 35A. Signal CASA 2 is coupled to banks 32A and 33A. Signal CASA 3 is coupled to banks 30A and 31A. Similarly, column select signals CAS B0 - B3 are provided to the memories of bank B; signal CAS C0-C3 are provided to bank C, and signal CAS D0-D3 are provided to bank D.

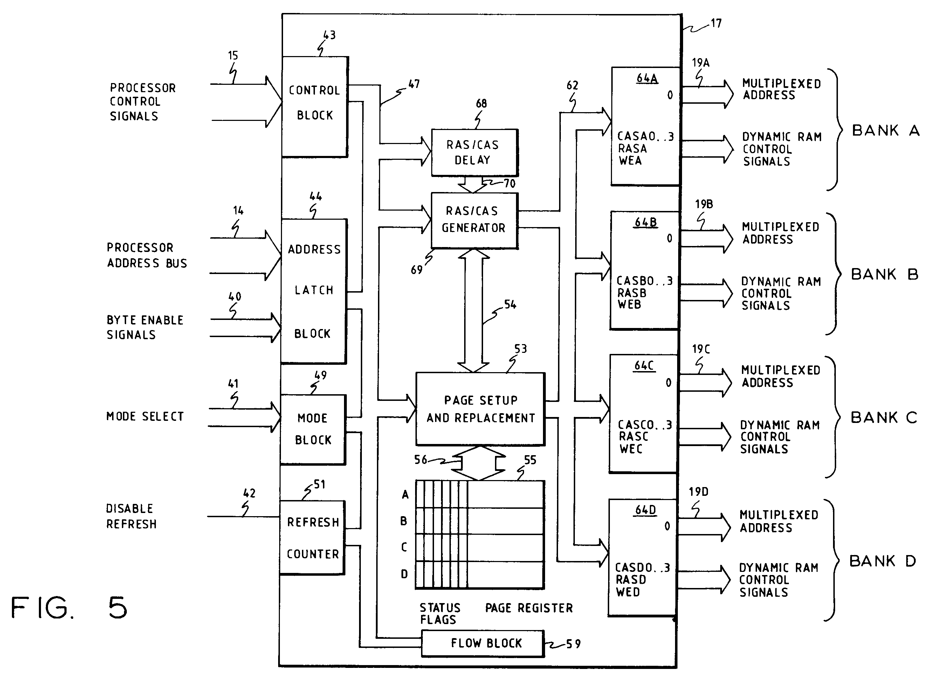

A detailed view of the DRAM controller 17 of Figure 3 is illustrated in Figure 5. The DRAM controller 17 is coupled to the processor control bus 15. The processor control bus 15 provides control signals to control block 43. The signals include W/R, D/C, M/O, Reset, ADS, Clock, RS16, and A20 gate signals. The processor address bus 14 provides address information to address latch 44. The control block 43 provides output signals 46 to bus 47. The delay line block 68 provides output signal 70 to the RAS/CAS generator block 69. A byte enable signal 40 provided by a microprocessor is coupled to the address latch block 44. The address latch 44 provides output on bus 47 to a page replacement block 53, logic block 55 and program flow detector block 59.

Mode select signals 41 are provided to mode control block 49. Mode control block 49 provides an output on bus 47 to RAS/CAS generator block 69. A disable refresh signal 42 is provided to refresh block 51. Refresh block 51 includes a counter so that appropriate rows and columns can be refreshed as desired. The refresh block 51 provides an output signal on bus 47 to the RAS/CAS generator block 69. The RAS/CAS generator block 69 is also coupled on bus 54 to replacement block 53. The page replacement block 53 includes an up/down counter and provides outputs 56 to 58 to logic block 55. The program flow detector block 59 provides output to bus 47.

The RAS/CAS generator block 69 provides output on bus 62 to output blocks 64A, 64B, 64C and 64D. The page replacement block 53 provides output on bus 62 to output blocks 64A-64D, respectively. The output blocks 64A-64D provides address information on busses 19A-19D respectively, to memory banks A through D. The output block 64A-64D also provide the row address signals, column address signals CAS 0-CAS 3 for each of the memory blanks and a write enable signal.

Because each memory bank has its own addresses, each memory bank also has its own page register. Thus, more pages can be "active" (accessible) than in prior art schemes. The more active pages, the higher the hit rate and lower the average access time.

PAGE REPLACEMENT ALGORITHM

The number of wait states is reduced by this invention because the number of ROW precharge cycles and long RAS/CAS access cycles are minimized. The key for setting up pages in advance most effectively is the algorithm behind the selection of the correct page selection of the remaining, non active pages.

The following variables are considered:
* Interleave factor 2/3/4 way (single bank without setup)
* Move of code and data -incrementing or decrementing-
* Random page setup
* Reload page after refresh
* Preload pages after reset

7

The movement of code and data fetches have distinct characteristics. A data fetch that is of random type will require setup of the remaining pages differently from a data fetch that is of sequential type which is likely to be either a stack access or a data transfer of an array.

If the current access is a code fetch, then the remaining pages are set up to the last data fetches that occurred. If the code or data fetch approaches the page boundary, automatically one adjacent page will be set up to allow a transition from one page to the next while the remaining pages will be set up for the data fetches.

PAGE DESCRIPTOR

There are two page descriptors for every bank called the current page descriptor block (CPDB) and the history page descriptor block (HPDB).

Every page descriptor consists of the bank number, a number of flags, and the page address. The page address size is determined after power up. A mask register for every page deselects the unused address bits. If a bit is set in the mask register, then the address bit is invalidated.

A page descriptor for every bank holds the information used for deciding how to set up the bank in advance. A page descriptor is configured as follows:
: B0 B1 H/CPDB\ ACT RF D/C\ RCC RCD:

B0 B1

These two bits contain the bank number.

H/CPDB\

If this bit is set, this page descriptor is the history page descriptor. The contents of the current page descriptor will be loaded into the history page descriptor after leaving the page.

ACT

This bit is set if the current access is to this bank and reset if the current access is to a different bank.

RF

This bit is set while the bank is refreshed. After refresh, the page is reloaded into the DRAM.

D/C\

This bit is set if the current access is a data fetch and is reset if the current access to this bank is code fetch.

RCC

If the page exit from random location and the access was a Code access, this bit will be set. This bit will be reset if the page exists sequentially.

RCD

If the page exit from random location and the access was a Data access, this bit will be set. This bit is reset if the page exists sequentially.

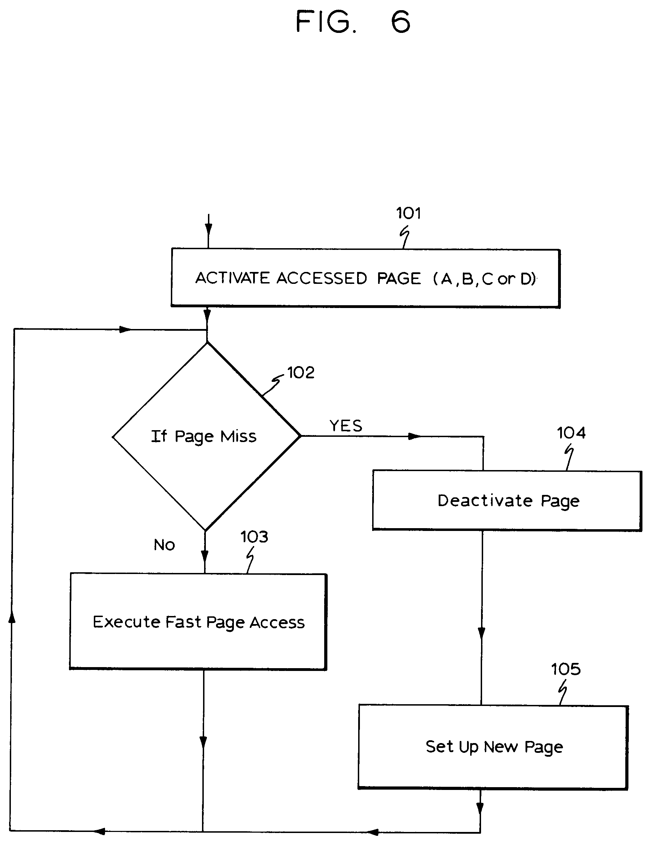

A flow chart of a memory access operation using the present invention is illustrated in Figure 6. At step 101, an attempt is made to activate an accessed page (a page accessed by the microprocessor). The availability of the accessed page is determined at decision block 102. If the page is not missing, that is, if it is found in one of the memory banks A,B,C,or D, the system proceeds to Step 103 and a fast-page access is executed.

If the accessed page is missing from memory banks A, B, C, and D, the system proceeds to step 104 and the page is de-activated. The system then moves to step 105 and a newpage setup is executed. The new page setup step is performed in accordance with the page prediction algorithm of this invention.

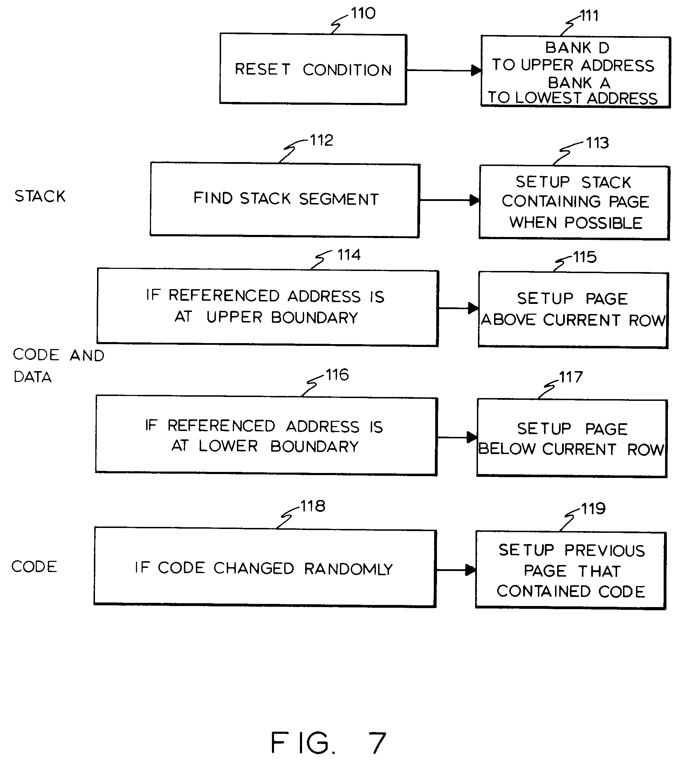

The page prediction algorithm of this invention uses a number of parallel operations as illustrated in Figure 7. In a reset condition 110, bank D is set to the uppermost address and bank A is set to the lowest address at step 111. For a stack access, the stacked segment is found at step 112. At step 113, the stack is set up to contain the accessed page when possible. For code and data accesses, if the referenced address is at the upper boundary at step 114, then the setup page should be above the current row at step 115. If the referenced address is at the lower boundary at step 116, the setup page should be below the current row at step 117. For a code access, if the code is changed randomly at step 118, the page setup is of the previous page that contained the referenced code at step 119.

The operations of Figure 7 are executed in parallel. For every memory access, a history is maintained in page descriptor registers. The history contains the last memory access and identifies it as a code access, data access, stack access, etc.

Therefore, a Method and Apparatus for Page Prediction for Multiple Page DRAM has been described.

**Claims**

1. A storage system characterized by
   a plurality of memory banks (20A-20D);
   a control means (17) coupled to a processing means (10) and to said plurality of memory banks, said control means for receiving memory page addresses from said processing means and for providing said memory page addresses to one of said plurality of memory banks dependent on said memory page address; and,
   said memory banks having an associated address space mapped into contiguous ones of said plurality of memory banks.

2. The storage system of claim 1 characterized in that said plurality of memory banks comprises four memory banks (20A-20D).

3. The storage system of claim 1 or 2, characterized in that said control means (17) includes a plurality of page registers, each of said page registers associated with one of said memory banks (20A-20D).

4. The storage system of claim 3 characterized in that said plurality of page registers comprises four page registers.

5. The storage system of claim 3 or 4 characterized in that each of said page registers contains a current page descriptor, associated with a currently accessed page of memory.

6. The storage system of claim 5 characterized in that each of said page registers contains a history page descriptor, associated with a previously accessed page of memory.

7. The storage system according to any of claims 1 to 6 characterized in that each memory bank (20A-20D) has associated row address signals (RAS) and associated column address signals (CAS).

8. The storage system according to any of claims 1 to 7 characterized in that said control means (17) comprises:
   a control block (43) for receiving control signals from said processing means (10);
   an address latch block (44) for receiving memory addresses and byte enable signals from said processing means;
   a refresh block (51) coupled to said processing means (10) for receiving a disable refresh signal;
   a first bus (47) coupled to said control blcok (43), said address latch block (44) and said refresh block (51);
   a row address signal (RAS) and column address signal (CAS) delay (68) and a row address signal and column address signal generator (69) coupled to said first bus (47);
   a page setup and replacement block (53) coupled to said first bus (47) and to said RAS/CAS generator (69);
   a register means (55) coupled to said page setup and replacement block (53) for storing said current page descriptor and said history page descriptors;
   a second bus (62) coupled to said RAS/CAS generator (69) and said page setup and replacement block (53); and

a plurality of output blocks (64A-64D) coupled to said second bus (62) for providing addresses and control signals to each of said memory banks (20A-20D).

FIG. 1

Processor 10 — Virtual Address — Cache 11 — MMU 12 — Physical Address — DRAM 13

FIG. 2

Processor 10 — Virtual Address — MMU 12 — Cache 11 — Physical Address — DRAM 13

# FIG. 3

EP 0 482 575 A2

FIG. 4

FIG. 5

# FIG. 6

101
ACTIVATE ACCESSED PAGE (A, B, C or D)

102
If Page Miss

YES

No

103
Execute Fast Page Access

104
Deactivate Page

105
Set Up New Page

RESET CONDITION ⟍110 → BANK D TO UPPER ADDRESS BANK A TO LOWEST ADDRESS ⟍111

STACK

FIND STACK SEGMENT ⟍112 → SETUP STACK CONTAINING PAGE WHEN POSSIBLE ⟍113

IF REFERENCED ADDRESS IS AT UPPER BOUNDARY ⟍114 → SETUP PAGE ABOVE CURRENT ROW ⟍115

CODE AND DATA

IF REFERENCED ADDRESS IS AT LOWER BOUNDARY ⟍116 → SETUP PAGE BELOW CURRENT ROW ⟍117

CODE

IF CODE CHANGED RANDOMLY ⟍118 → SETUP PREVIOUS PAGE THAT CONTAINED CODE ⟍119

FIG. 7